# EUROPEAN PATENT APPLICATION

(11) **EP 0 905 745 A2**
(43) Date of publication of application: **31.03.1999**
(21) Application number: 98202983.7
(22) Date of filing: 07.09.1998
(51) Int. Cl.: H01L 21/00

(54) **Semiconductor device manufacting apparatus**

(30) Priority: 25.09.1997 JP 278296/97; 03.12.1997 JP 348641/97; 16.06.1998 JP 185567/98
(71) Applicant: Innotech Corporation, Yokohama-shi, Kanagawa-ken 222-8580 (JP)
(72) Inventor: Yoshida, Minoru, Yokohama-shi, Kanagawa-ken 222-8580 (JP); Nishikubo, Yasuhiko, Yokohama-shi Kanagawa-ken 222-8580 (JP)
(74) Representative: Fieret, Johannes, Ir.

(57) **Abstract**

An objective of this invention is to increase the semiconductor device production efficiency by simplifying the transport route of a wafer substrate in semiconductor device manufacturing apparatus. Another object is to provide apparatus that avoids the need for a large-scale cleanroom.

To attain the foregoing objects, unit process groups are constituted from a plurality of processing mechanisms such as washing and film fabrication or the like at the process for forming the individual one of layers of a wafer substrate, while comprising an ensemble of unit process groups with these plural process groups being serially disposed along a main transport path for use in transferring the wafer substrate.

Also provided is a unit process group connected to the main route for transportation of the wafer substrate, this unit process group being such that a plurality of processing mechanisms such as washing and film formation and others at the steps of forming individual layers of the wafer substrate are serially disposed in the order of processing the wafer substrate.

## Description

This invention relates to semiconductor device manufacturing apparatus.

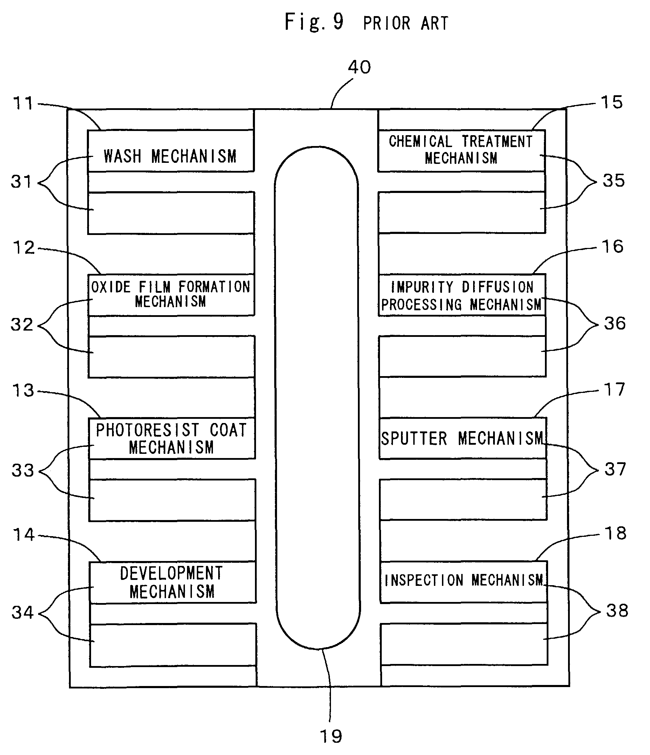

One prior known semiconductor device manufacturing apparatus will be explained with reference to Figs. 9 to 12.

This manufacturing apparatus is of the so called bay system, which is structured from process bays including a plurality of processing mechanisms of the same kind as installed therein.

As shown in Fig. 9, a plurality of process bays 11-18 corresponding to the kinds of processing steps are provided inside a cleanroom 40.

Next, an explanation will be given of the processing mechanisms installed in respective process bays 11-18 along with the processing at there.

A washing mechanism 31 for use in washing the surface of a wafer substrate is installed in a washing process bay 11.

An oxide film formation mechanism 32 is installed in an oxide film formation process bay 12, wherein an oxide film is formed on the wafer substrate surface as a protective film.

In addition, a photosensitive-material coating process bay 13 and development process bay 14 are the process bays for use in performing photolithography processing, wherein a photoresist coating mechanism 33 is installed in the process bay 13, whist a developer mechanism 34 is in the process bay 14. At the development process bay 14, processing is carried out including mounting on a photoresist a mask in accordance with a necessary pattern for effectuation of light exposure, and then, removing those photoresist portions that remain non-sensitized.

At a chemical treatment process bay 15, chemical treatment is performed including removing an unnecessary material on the wafer substrate surface, e.g., a portion of the oxide film. A chemical treatment mechanism 35 used for such processing is installed.

At an impurity diffusion process bay 16, an impurity diffusion processing mechanism 36 is installed for diffusing an impurity into the wafer substrate. An impurity gas of the kind required in accordance with a layer to be formed is introduced into this impurity diffusion processing mechanism 36.

Further, a sputter mechanism 37 for use in forming a thin-film is installed in a sputter process bay 17, whereas a wafer substrate inspection mechanism 38 is installed in an inspection process bay 18.

A monorail 19 is installed for connection between respective process bays described above. A carrier box, not shown, mounting thereon a wafer substrate to be processed moves on this monorail 19 for transportation of the wafer substrate to respective process bays 11-18.

In addition, an automatic transport device for exclusive use within the inside of process bay is provided in each of the process bays 11-18. This automatic transport device is operable to bring down a wafer substrate from the carrier box on the monorail 19 and transfer it inside the process bay and then perform necessary processing at there. It is arranged such that after completion of such processing, the substrate is again returned to the carrier box.

Each process bay is also arranged so that a plurality of processing mechanisms of the same kind are installed therein to thereby enable a plurality of wafer substrates once transferred thereto to be processed simultaneously.

Since the number and the order of processing steps necessary for manufacturing a single semiconductor device are different depending on the product type, a control CPU is provided for selecting a transport route for transferring the wafer substrate.

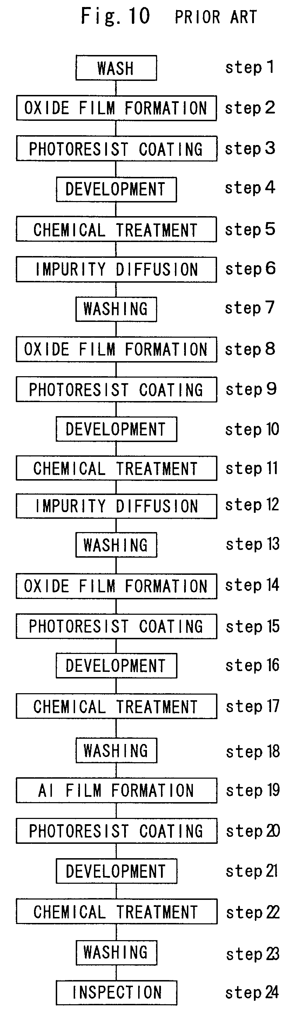

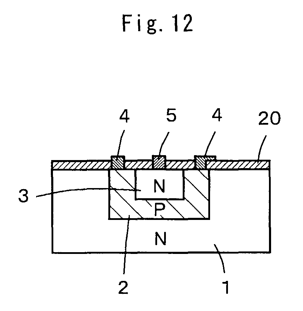

In the manufacturing apparatus of the bay system type, a method for manufacturing a transistor shown in Fig. 12 which is one semiconductor device will be explained in accordance with the flow chart of Fig. 10. Note here that this transistor is in the form in which a P-type layer 2 is laid between N-type layers 1, 3 with electrodes 4, 5 being exposed to the surface and with the remaining parts protected by an oxide film 20.

First, mount an N-type silicon wafer substrate on the carrier box on the monorail 19 for transportation toward the process bay 11. At step 1, wash the wafer substrate inside the process bay 11.

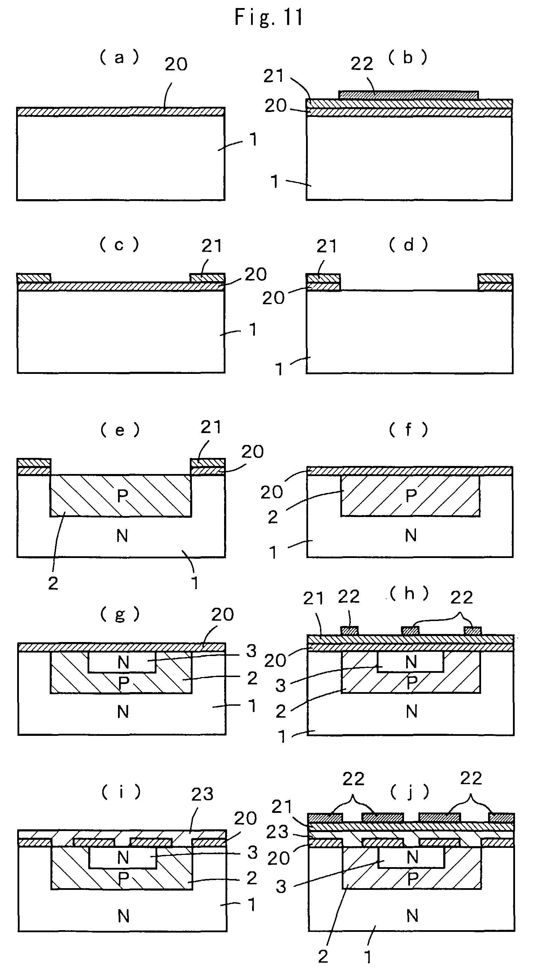

After washing is completed, the wafer substrate moves by the monorail 19 to the process bay 12 thereby proceeding to step 2. At step 2, fabricate an oxide film 20 on the wafer substrate surface (see Fig. 11(a)); thereafter, transfer the wafer substrate to the process bay 13.

At step 3, deposit and coat a photosensitive material on the entire surface of the oxide film 20.

At the development process at step 4 in the process bay 14, perform light exposure with a mask 22 that corresponds to the P-type layer 2 being mounted on the photosensitive material 21 as shown in Fig. 11(b); then, remove any non-sensitized portions, i.e. those photosensitive material portions of the mask 22 (see Fig. 11(c)).

Next, transfer the wafer substrate to the process bay 15, and remove by a chemical treatment process at step 5 those portions of the oxide film at which no photosensitive materials are present. Then, as shown in Fig. 11(d), certain part with the N-type layer 1 exposed directly is obtained. In this state, transfer the wafer substrate to the process bay 16 thus going next to step 6.

At step 6 the impurity diffusion processing mechanism 36 of the process bay 16 is used letting a P-type impurity diffuse. Due to this diffusion processing, a P-type layer 2 is formed within the wafer substrate as shown in Fig. 11(e).

At step 7, transfer the wafer substrate to the process bay 11 again to perform washing thereby removing the photosensitive material 21 residing on the surface.

Transfer the wafer substrate to the process bay 12; at step 8, form an oxide film 20 so that the surface of the P-type layer 2 is also protected by the oxide film 20 as shown in Fig. 11(f).

At steps 9 to 12 following this state, an N-type layer 3 is formed through the photosensitive material coating process -> development process -> chemical treatment process -> impurity diffusion process in a way similar to that at the steps 3-6 stated supra. Note here that in the development process at step 10, exposure is done while mounting a mask corresponding to the shape of the N-type layer 3.

Next, transfer the wafer substrate to the process bay 11; at step 13 washing is carried out for removal of any unnecessary photoresistive material 21; then, transfer it to the process bay 12.

At step 14, again form an oxide film 20. Whereby, the entire surface of the wafer substrate is covered by the oxide film 20 as shown in Fig. 11(g).

Thereafter, Al (aluminum) electrodes 4, 5 in Fig. 12 are formed through the steps 15-22.

To do this, define windows in the oxide film 20 at steps 15-18. These windows correspond to certain parts used for removal of the oxide film 20 in order to directly attach the Al electrodes to the surfaces of the P-type layer 2 and N-type layer 3.

First, at step 15, coat a photosensitive material 21 on the oxide film 20 of Fig. 11(g) in the process bay 13.

At step 16, transfer the wafer substrate to the process bay 14, in which exposure is done while the mask 22 corresponding to the aforesaid windows is mounted as shown in Fig. 11(h).

At step 17, effectuate chemical treatment to remove those parts of the oxide film 20 which correspond to the windows, i.e. the electrodes; then, form the windows. Further, washing is done in the process bay 11 to thereby remove the remaining photosensitive material 21 (step 18).

In order to fabricate an Al film 23 for use as electrodes, transfer the wafer substrate to the sputter process bay 17. Here, form the Al film 23 (step 19). Here, the Al film 23 is formed on the entire surface as shown in Fig. 11(i), wherein certain parts are present which are in direct contact with the Al film 23 respectively at the P-type layer 2 and N-type layer 3 in a way corresponding to the windows as formed previously so that such parts become the electrodes.

At step 20 a photosensitive material 21 is again coated on the Al film 23 in the process bay 13 (Fig. 11(j)).

During the development process at step 21, development is performed with the mask 22 mounted as shown in Fig. 11(j), the mask leaving the shape of electrode as exposed to the surface.

By chemical treatment process at step 22, remove any non-sensitized portions of the photosensitive material 21 along the underlying Al film 23.

Thus, the P electrode 4 and N electrode 5 are completed.

Further, at step 23, washing is done to remove the remaining photosensitive material 21 thereby completing the transistor.

The transistor thus obtained is then transferred to the process bay 18 for inspection.

In the case the transistor being as the semiconductor device is manufactured in the way described above, the processing of twenty four steps in the flowchart of Fig. 10 is carried out for the wafer substrate in the eight process bays 11-18 of Fig. 9. The fact that the processing steps are greater in number than the process bays in the scheme stated previously means that a single process bay is used to perform the processing for many times. In other words, the carrier box with a wafer substrate mounted thereon must pass the same route on the monorail 19 for many times while it transfers such single wafer substrate to the same process bay for many times. For example, in the prescribed process, the monorail 19 transports the wafer substrate to the wash process bay 11 for five times, to the oxide film formation process bay 12 for three times, to each of the photosensitive-material coat process bay 13 and development process bay 14 as well as chemical treatment process bay 15 for four times, to the impurity diffusion process bay 16 for two times, and each of the sputter process bay 17 and inspection process bay 18 for one time.

Using the reference numerals adhered to respective process bays, the order of transportation of the wafer substrate to these process bays may be represented as follows: 11 -> 12 -> 13 -> 14 -> 15 -> 16 -> 11 -> 12 -> 13 -> 14 -> 15 -> 16 -> 11 -> 12 -> 13 -> 14 -> 15 -> 11 -> 17 -> 13 -> 14 -> 15 -> 11 -> 18.

In the case where a single transport box is designed to travel along a complex route in the way such that it is transferred to a single process bay for many times, when an attempt is made to transfer a plurality of carrier boxes, the resulting route can intersect a route of another carrier box. This would result in that either one of such "colliding" carrier boxes must wait while the other passes the route. Alternatively, in cases where the process steps using the same processing mechanism are occurred at a time, either one is required to wait since a single process bay cannot execute multiple processing tasks simultaneously.

Especially, as the processing increases in total step number, the resultant number of process steps included therein which utilize the same processing mechanism or the same process bay increases accordingly. This results in an increase in transport route length, thus reducing productivity. While the productivity can decrease with a mere increase in length of the route of a single transport box, the productivity can further be reduced when the wait time is lengthened due to the route intersection or collision with another carrier box along a route.

In addition, this prior art apparatus has strictly required the use of a large-scale cleanroom capable of accommodating all the processing mechanisms and transport routes concerned.

It is therefore an object of this invention to enhance the production efficiency of semiconductor devices by simplifying the transport route of a wafer substrate in semiconductor device manufacturing apparatus. Another object is to provide apparatus capable of avoiding the need for a large-scale cleanroom.

An apparatus for manufacturing a semiconductor device in accordance with a first invention is featured in that unit process groups are each constituted from a plurality of processing mechanisms including washing and film formation and the like at the steps of forming individual layers of a wafer substrate, and by comprising unit process groups wherein these plurality of unit process groups are serially disposed along the main route for transportation of the wafer substrate.

A second invention is featured by comprising unit process groups connected to the main route for transportation of a wafer substrate, and in that these unit process groups include a plurality of processing mechanisms such as washing and film formation or the like at those process steps of forming individual layers of the wafer substrate, the mechanisms being serially disposed in the order of sequence of processing the wafer substrate.

A third invention is based on the first invention and is featured in that the unit process groups include a unit process group having a plurality of processing mechanisms which are serially disposed in the order of sequence of processing the wafer substrate.

A fourth invention is based on the second invention and featured in that a plurality of unit process groups are serially disposed along the main route for transportation of a wafer substrate.

A fifth invention is featured in that one or more branch routes diverted from the main route are provided, and that a specific processing mechanism selected from all the processing mechanisms is installed on the branch routes.

A sixth invention is featured in that a clean bench is provided at predetermined intervals along the route for transportation of a wafer substrate, that this clean bench injects clean air against the transport route, and that a clean space is formed between the route and the clean bench.

A seventh invention is featured in that an air guide extending downward is provided at an edge of the clean bench along the wafer substrate transfer direction.

An eighth invention is featured in that a fence member surrounding the clean space is provided between the clean bench and the transport route.

A ninth invention is featured in that an air exhaust port is provided beneath the clean space.

A tenth invention is featured by comprising a transport mechanism including a transport route consisting of one or both of a main route and a branch route as well as a carrier body that is movable along the transport route with a wafer substrate mounted thereon, a position detection mechanism for detecting the position of the carrier body that this transport mechanism has, and a control CPU for letting the carrier body move or step in accordance with a detection signal from the position detection mechanism.

An eleventh invention is featured in that the position detection mechanism comprises an address ID representative of a position provided along the transport route and an ID sensor for reading the address ID provided to the carrier body, and that the ID sensor transmits to the control CPU the address ID as read during traveling whereas the control CPU controls motion of the carrier body on the basis of the address ID sent thereto.

A twelfth invention is featured in that unit process groups accommodating any possible product types are provided along the transport route of the wafer substrate, and that the control CPU selects only unit process group or groups required during traveling of the carrier body.

A thirteenth invention is featured by comprising a processing mechanism group including a plurality of successive processing mechanisms of the same type which are less in processing ability than the other processing mechanisms as provided along the transport route, and more than one refuge area provided at a portion corresponding to the processing mechanism group along the transport route, and in that the control CPU controls a plurality of carrier bodies movable on the transport route and also forces a carrier body transferring a wafer substrate to the processing mechanism group to stop in the refuge area thereby enabling its following carrier body to pass the stopping carrier body.

A fourteenth invention is featured by comprising a random unit process group wherein processing mechanisms are disposed at random as in the bay scheme.

It should be noted that the semiconductor device manufacturing apparatus of this invention should not always be arranged to include all the process steps in the manufacture of semiconductor devices, and may also be designed in principle to at least partly includes those necessary process steps.

It is also noted that the arrangement of serially disposing the unit process groups along the wafer substrate transport path may refer to an attempt to align the unit process groups in the order of sequence of the wafer substrate manufacturing process steps.

### Brief Description of the Drawings

Fig. 1 is a schematical 3D diagram of a manufacturing apparatus of a first embodiment.
Fig. 2 is a flow chart of unit process groups of the first embodiment.
Fig. 3 is a block diagram representing a configuration of the unit process groups of the first embodiment.
Fig. 4 is a block diagram schematically representing an overview of a manufacturing apparatus of a second embodiment.
Fig. 5 is a block diagram representing an overview of a manufacturing apparatus of a third embodiment.
Fig. 6 is a block diagram representing an overview of a manufacturing apparatus of a fourth embodiment.
Fig. 7 is a block diagram representing an overview of a manufacturing apparatus of a fifth embodiment.
Fig. 8 is a block diagram representing an overview of a manufacturing apparatus of a sixth embodiment.
Fig. 9 is a schematic diagram of one prior art manufacturing apparatus.
Fig. 10 is a flowchart of the manufacture of a transistor in the prior art.
Fig. 11 is a diagram for explanation of the manufacturing procedure of the transistor, wherein (a)-(j) are diagrams showing sequentially the states during manufacture.
Fig. 12 is a sectional view of the transistor.

### Preferred Embodiments of the Invention

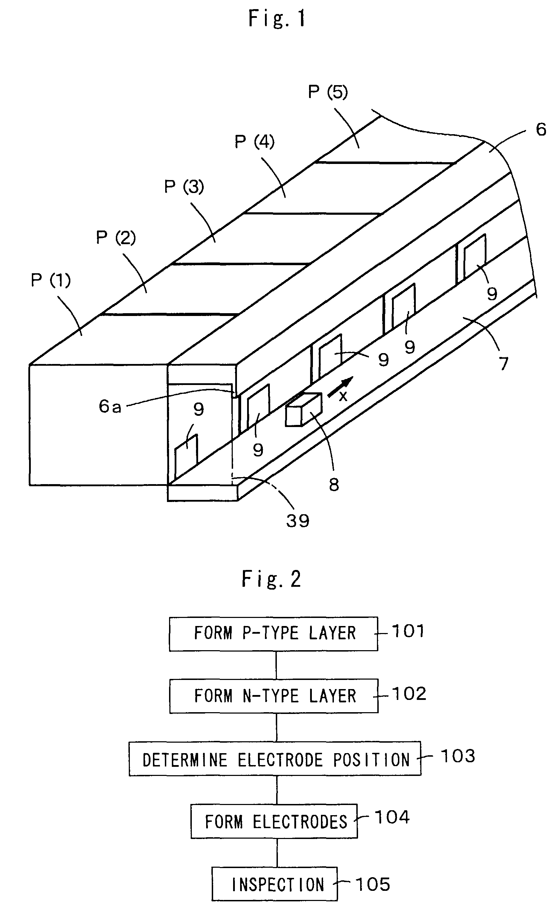

A first embodiment shown in Figs. 1-3 is a manufacturing apparatus including a single lateral array of a plurality of process boxes P(1), P(2) ... along a transport path 7 which is the main route of this invention. This transport path 7 is designed to permit an automatic carrier vehicle 8--this mounts thereon a clean box of the sealed type, not shown--to move along the transport path 7 for transportation of a wafer substrate as placed in the clean box.

Also, a clean bench 6 is provided over the transport path 7.

This clean bench 6 is to inject clean air against the underlying transport path 7 thereby forming a clean space 39 surrounded by dash-and-dot lines between the clean bench 6 and transport path 7. In addition, the clean bench 6 has one edge section at which a down-going air guide 6a is provided for enabling adjustment of the downward flow of clean air. This flow along the air guide 6a functions as an air curtain. Accordingly, the clean air as injected into the clean space 39 will no longer attempt to escape or outflow from the clean space 39.

It is thus ensured that the clean box traveling along the transport path 7 is constantly transferred within a clean atmosphere.

The interior of a respective one of the process boxes P(1), P(2) ... is such that an ensemble of several kinds of processing mechanisms necessary for processing of forming individual layers on the wafer substrate are provided constituting a single unit process group. These unit process groups are serially disposed along the transport path 7 to thereby constitute the unit process groups of this invention. These are for execution of a series of processing tasks in accordance with the layout order of the aforesaid unit process groups, i.e. the process boxes.

Here, the process for manufacturing a transistor of the prior art structure described previously in conjunction with Fig. 12 will be explained below. This manufacturing process is the same as the flowchart shown in Fig. 10.

In short, all the processing functions for completing the flow of Fig. 10 are achieved by the unit process groups in respective process boxes P(1), P(2) ....

An explanation will now be given of how the respective process groups constituting the manufacturing apparatus of this invention are structured from which one or ones of the processing mechanisms.

Respective unit process groups are those which are configured by dividing twenty four processing functions corresponding to the steps 1 to 24 of all the process tasks shown in Fig. 10 into five groups. The resulting processing functions within each unit process group thus arranged is the same in sequence as that in the flow of Fig. 10.

It is noted that while this group division is carried out in view of process functions, it is not absolute one. A plurality of steps to be considered as a series of processes for formation of the individual layers of a wafer substrate are combined together and contained in the same group.

Accordingly, in the first embodiment, the step 1 to step 24 in the flowchart of Fig. 10 are arranged to correspond to a flow consisting of five process groups 101-105 as shown in Fig. 2.

The first process group 101 corresponds to the steps 1-6 which are for forming the P-type layer 2 of the transistor, whist the second process group 102 corresponds to the steps 7-12 which are for fabricating the N-type layer 3. In addition, the third process group 103 corresponds to the steps 13-15 which are for determining positions whereat electrodes will be formed; the fourth process group 104 is the process of forming Al electrodes; and, the fifth process group 105 is the inspection process.

Note here that the Al electrode formation process is constituted from two groups: the third process group 103 for determination of the electrode position by defining windows in an oxide film on the side of a surface whereat the semiconductor is in contact with the electrode, and the fourth process group for formation of the shape of an externally exposed side.

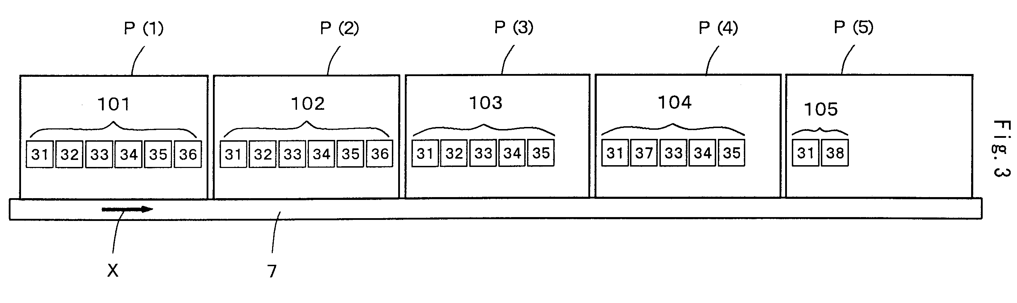

As shown in Fig. 3, each of the process boxes P(1)-P(5) includes several processing mechanisms installed therein, which are necessary processing mechanisms for use in each process. Here, the processing mechanisms installed in respective process boxes P(1)-P(5) are the same in kind as those installed within the prior art process bays 11-18. The mechanisms of the same kind are designed by the same reference numerals.

The process box P(1) of the first process group includes those mechanisms necessary for formation of the P-type layer 2 as installed therein. More specifically, a washing mechanism 31, oxide film formation mechanism 32, photosensitive material coating mechanism 33, development mechanism 34, chemical treatment mechanism 35, and impurity diffusion processing mechanism 36 are installed.

In the process box P(2) of the second process group, the same kinds of processing mechanisms as those in the process box P(1) of the first process group are installed as the processing mechanisms for use in forming the N-type layer 3. Note however that a mask pattern used during development and the kind of a gas as introduced into the impurity diffusion processing mechanism 36 in the second process group are different from those in the first process group.

In the process box P(3) of the third process group, those processing mechanisms for use in forming windows in an oxide film to define places to provide electrodes are installed, including the wash mechanism 31, oxide film formation mechanism 32, photoresist coat mechanism 33, development mechanism 34, and chemical treatment mechanism 35.

The fourth process group is the process for forming Al electrodes: in the process box P(4), a sputter mechanism 37 is installed in addition to the wash mechanism 31, photoresist coat mechanism 33, development mechanism 34, and chemical treatment mechanism 35.

In the last process box P(5), the wash mechanism 31 and inspection mechanism 38 are installed.

The above-mentioned five process boxes P(1)-P(5) are linearly arrayed along the transport path 7 of the automatic carrier vehicle 8 for transferring a clean box. In addition, an entrance/exit port 9 for use in loading and unloading the clean box is formed in each of the process boxes P(1)-P(5).

Note that a wafer substrate transfer mechanism, not shown, is provided along with the processing mechanisms mentioned above inside a respective one of the process boxes P(1)-P(5). This wafer substrate transfer mechanism is for receiving the clean box from the entrance/exit port 9 to transfer it up to each processing mechanism. Also provided therein is a prior known mechanism capable of setting to each processing mechanism the wafer substrate within the clean box without exposing it to the outside air.

In the manufacturing apparatus thus arranged, a method for manufacturing the transistor shown in Fig. 12 will be explained below.

The automatic carrier vehicle 8 mounting thereon the clean box of the closed type with a wafer substrate housed therein moves only in the direction of arrow X in Figs. 1 and 3 to sequentially transfer the clean box to the process boxes P(1)-P(5) in this order.

Firstly, the clean box enters the interior of the process box P(1) through the entrance/exit port 9 of process box P(1). Inside the process box P(1) the processing of forming the P-type layer 2 is performed for the wafer substrate thus transferred. After completion of this processing, the wafer substrate is returned to the clean box, which is then conveyed by the automatic carrier vehicle 8 to move to the neighboring process box P(2).

Within the process box P(2) also, necessary processing is carried out causing the clean box that leaves it to move to the next process box P(3).

Thereafter, similar operations will be repeated performing the processing procedures at the process boxes P(4) -> P(5), thus completing the intended product.

In this way, since all the processing steps are effectuated while the automatic carrier vehicle 8 merely moves in a single direction, it is no longer necessary for the automatic carrier vehicle 8 to reciprocally move along the transport path 7. In other words, it becomes possible to complete the necessary processing without requiring the vehicle to pass through any "futile" transport route segments. Thus, the manufacturing efficiency increases accordingly.

Also, even where a plurality of automatic carrier vehicles 8 are employed which move simultaneously along the transport path 7, it will hardly happen that the travel routes of such automatic carrier vehicles 8 intersect each other as far as an appropriate distance is maintained.

Furthermore, unlike the prior art, it will no longer happen that the same process box must be used for effectuation of processing at different steps; therefore, it will neither happen that a plurality of clean boxes are gathered at the same process box resulting in formation of a queue of many boxes while one box is being processed at there.

Therefore, a wait time will not generate thereby enabling achievement of production with enhanced efficiency.

Although in the first embodiment one specific manufacturing apparatus for use in fabricating a simple transistor shown in Fig. 12 was employed as an example for purposes of simplifying the explanation only, it is permissible that additional unit process groups are provided with an increase in process step number and thus extra process boxes may also be employable accordingly. Obviously, the unit process groups may be reduced in number where necessary.

It is also noted that while the scheme for partitioning the unit process groups should not exclusively be limited to the first embodiment, facility costs may be reduced when multiple process boxes are structured from identically the same processing mechanisms as in the process boxes P(1) and P(2).

It is further noted that in the first embodiment, the clean bench 6 is provided over the transport path 7 for use with the clean box carrying a wafer substrate while forming the clean space 39 between the transport path 7 and clean bench 6, thereby avoiding the need for the cleanroom used in the prior art. In other words, while the prior art does require use of a large-scale cleanroom capable of installation of all the processing mechanisms and the transport route associated therewith, the illustrative embodiment may avoid the need for such large cleanroom.

In order to further efficiently form the clean space 39 utilizing the clean bench 6 as described above, it is effective that the flows of clean air from the clean bench 6 are adjusted so that these are in the downward direction.

To do this, in this embodiment, the air guide 6a is provided at the elongate edge of the clean bench 6 along the transport path 7. It will also be considered that this air guide 6a reduces a flow of air attempting to escape to the outside of the clean space 39, by either increasing the length thereof in the downward direction or providing a fence, such as for example a wall or door, between the clean bench 6 and transport path 7. With such an arrangement, efficient cleaning will be achievable within the clean space 39.

Additionally, if an air exhaust port is provided beneath the clean space 39, such port will be useful for adjustment of the flow of clean air. For example, in cases where the clean space 39 is completely closed by a fence, the clean air flow may be adjusted by forming holes in the bottom of such fence, or alternatively, by forming punch holes in the surface of the transport path 7.

Optionally, if such air exhaust port is provided with a forced air exhaust means, it becomes possible to further uniformly adjust the clean air's flow direction.

If clean air is controlled to face the transport route surface with a less waste, it is possible to likewise reduce the flow amount of clean air from the clean bench, thus decreasing the size of the clean bench.

Note that while the clean bench 6 is employed in the first embodiment, such clean bench 6 will be unnecessary if the transport path 7 and unit process groups are installed in the interior of a cleanroom used.

Note however that since there is provided a certain mechanism capable of setting a wafer substrate in a clean box at each processing mechanism without exposing it to the outside air, it is not strictly required that the degree of cleanliness of the cleanroom for installation of such manufacturing apparatus be increased excessively. In the prior art semiconductor manufacturing apparatus shown in Fig. 9, the apparatus must be installed in a cleanroom of the class 1 or higher; in contrast, it is permissible for the cleanroom for installation of the apparatus embodying the invention that the degree of cleanliness is about the class 1000.

Also, in the first embodiment, the processing mechanisms that constitute respective unit process groups 101-105 are serially disposed in the order that a wafer substrate is to be processed. Due to this, even within the process boxes P(1)-P(5) corresponding to respective unit process groups 101-105, the wafer substrate may be simply driven to move in a single direction without having to pass through complicate transport route segments.

Note here that the processing mechanisms within each unit process group are not always such that all of them are disposed in the order of process steps. With a configuration in which only some of such unit process groups are disposed in the process step order, the wafer substrate transport route may be simplified in configuration as compared to the prior art thereby increasing the production efficiency. In this case, the remaining unit process groups may be disposed at random rather than in a serial layout in the process step order.

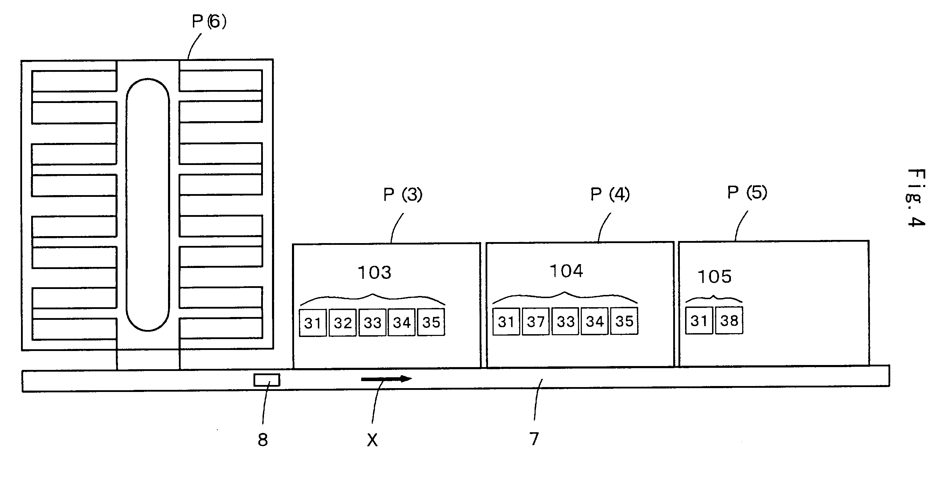

It is a second embodiment of Fig. 4 that presents a manufacturing apparatus comprising the foregoing random unit process groups with the above described processing mechanisms being randomly disposed.

In the second embodiment, a process box P(6) which is such random unit process group is installed in the alternative of the process boxes P(1), P(2) of the first embodiment shown in Fig. 3. The process boxes P(6), P(3), P(4), P(5) installed along the transport path 7 are arranged to constitute the unit process groups that are disposed in a serial array.

This process box P(6) employs the bay scheme and installs in its interior the processing mechanisms which are the same as those installed in the process box P(1) of Fig. 3. This process box P(6) performs therein the processing of the first process group 101 and that of the second process group 102 used in the first embodiment.

In other words, the process steps of forming the transistor's P-type layer 2 and N-type layer 3 (see Fig. 12) are formulated into a single unit process group, and processing of this unit process group is achieved by a single bay-system machinery.

An explanation will be given of a method for manufacturing the transistor shown in Fig. 12 by use of the manufacturing apparatus arranged as described above.

First, a clean box that has been transferred on the transport path 7 is loaded into the process box P(6) for forming the P-type layer 2 and N-type layer 3 (see Fig. 12) on a wafer substrate on a wafer substrate within this process box P(6). The formation of such P-type layer 2 and N-type layer 3 is the same in procedure as the prior art. The wafer substrate completed with this processing is returned to the clean box; then, the clean box is caused by the auto carrier vehicle 8 on the transport path 7 to move toward the neighboring process box P(3).

Thereafter, the wafer substrate is conveyed by the automatic carrier vehicles 8 to travel along the transport path 7 to undergo several treatments at the process boxes P(3) to P(5) in a way similar to that in the first embodiment, thereby completing the intended product.

In this way, use of the serial array of the unit process groups along the transport path 7 makes it possible to eliminate a need for the automatic carrier vehicles 8 to travel unnecessarily reciprocally or "migrate" on the transport path 7, which may in turn enable achievement of efficient manufacture of semiconductor devices.

As in the second embodiment, the bay-system apparatus is configured from the process box P(6) resulting in the wafer substrate having to move recurrently or "migrate" inside the process box P(6); however, the travel route of the wafer substrate will not become so complex because all the processes are not carried out therein unlike the prior art.

In addition, since respective processing mechanisms within the process box P(6) are for performing only the process tasks of the first process group 101 and second process group 102, the resulting structure may be reduced in size to be smaller than the processing mechanisms in the prior art. Conventionally, such processing mechanisms are used in performing all the process processing tasks so that it has been required to provide high-performance processing mechanisms high in processing ability. For this reason, the processing mechanisms are increased in size, which results in a need for a large-scale cleanroom.

Furthermore, in this embodiment, a single process box P(6) is specifically arranged to perform the processes of two unit process groups 101 and 102 of the first embodiment; hence, it is becomes possible to shorten the transport path 7 as compared to the first embodiment which employs the layout of identically the same process boxes P(1), P(2).

Additionally, it will possibly happen that depending on the product type and/or process required, it is difficult to lay out the processing mechanisms in the process order, or alternatively, migrational travel among the processing mechanisms is rather convenient.

For example, in the process of recurrently using the same processing mechanism within a shortened time period, iterative use of a single machine will be better in efficiency than an arrangement of several processing mechanisms of the same type being arrayed inside a single unit process group.

It should also be noted that in cases where the processing condition and procedure are not established with respect to a certain process so that trial-and-error attempts must be made repeatedly, mere serial layout of all the processing mechanisms in the processing order should require modification or alteration of the layout of processing mechanisms every time the procedure is changed. In such cases, provision of random unit process group or groups will become convenient.

Note also that there are no specific limitations in determining which part of the wafer substrate processing treatments is to be implemented as the random unit process group, such as the process box P(6) stated supra.

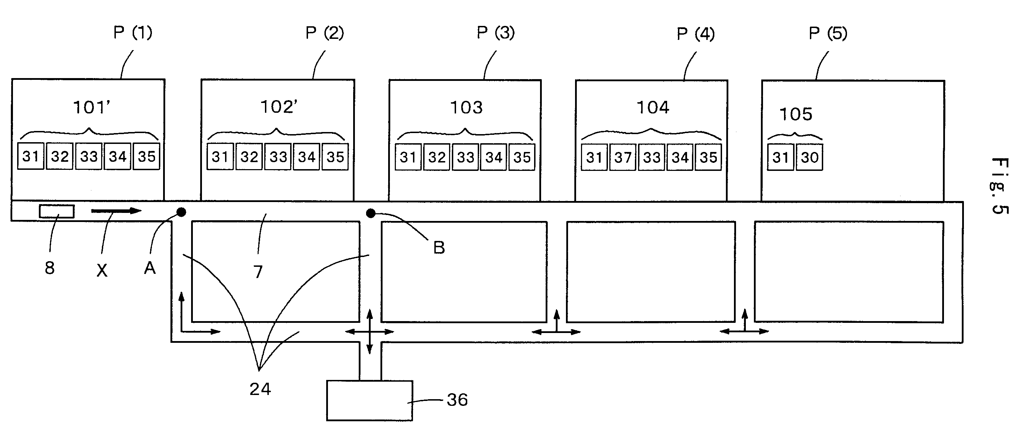

A third embodiment shown in Fig. 5 is a manufacturing apparatus employing branch routes 24 as diverted from the transport path 7 that defines the main route. An impurity diffusion processing mechanism 36 is installed in the branch routes 24. Clean benches 6 are also provided along the branch routes 24 for maintaining cleanliness in a way similar to that in the transport path 7. The auto carrier vehicle 8 mounting thereon a clean box is capable of moving along the branch routes 24 in directions as designated by arrows.

A first process group 101' in this apparatus is such that the impurity diffusion processing process is excluded from the first process group 101 of the first embodiment; a second process group 102' is the second process group 102 of the first embodiment with its impurity diffusion processing process excluded therefrom. In other words, the first process box P(1) and box P(2) of Fig. 5 do not come with the impurity diffusion process mechanism 36. Those unit process groups corresponding to the process boxes P(1) to P(5) constitute the unit process groups of this invention.

The remaining wafer substrate processing methods within process boxes, transfer methods and the like are similar to those in the first embodiment. Also, the same reference numerals are used to designate the same devices as those of the first embodiment.

An explanation will next be given of the case the manufacturing apparatus of the third embodiment is used to manufacture the transistor shown in Fig. 12.

After the auto carrier vehicle 8 mounting thereon its clean box transfers the wafer substrate to the first process box P(1) and the processing of the first process group 101' is completed, the wafer substrate is returned to the clean box. The auto carrier vehicle 8 mounting thereon the clean box leaves a branch point "A" of the transport path 7 defining the main route to enter one branch 24. Then, transfer the wafer substrate to the impurity diffusion processing mechanism 36 as installed in the branch route 24. Here, impurity diffusion processing is carried out for fabrication of the P-type layer 2 (see Fig. 12). Having completed this processing, the clean box housing therein the wafer substrate is again returned to the branch point "A" of the transport path 7. The auto carrier vehicle 8 travels along the transport path 7 in the arrow X direction and transfers the wafer substrate to the neighboring, second process box P(2).

At the second process box P(2) the processing of the second process group 102' is performed. Thereafter, the auto carrier vehicle 8 with the clean box mounted thereon leaves a branch point B of the transport path 7 to enter the branch route 24. And, it transfers the wafer substrate to the impurity diffusion processing mechanism 36 for effectuation of impurity diffusion processing of the N-type layer 3 (see Fig. 12). After completion of this processing, the auto carrier vehicle 8 again returns to the branch point B of the transport path 7, and then travels on the transport path 7 in the arrow X direction.

Thereafter, the wafer substrate is sequentially transferred in the order of the third process box P(3) -> the fourth process box P(4) -> the fifth process box P(5). This process here is identically the same as that in the first embodiment so that an explanation thereof is omitted.

In the third embodiment the branch routes 24 are provided while causing the impurity diffusion processing mechanism 36 to be externally removed from respective process boxes for association with the branch routes 24, for the reason which follows.

While impurity diffusion methods include an ion implantation method, gas diffusion method and the like, ion implantation devices and gas diffusion furnaces for use in performing such processing are relatively large in scale, and are capable of processing many wafer substrates at a time in most cases. In cases where such devices high in processing performance are linearly arrayed for use with the remaining devices low in processing performance, it will possibly happen that the processing of such devices is finished earlier thereby lengthening a wait time period in which the devices are in rest. This would result in lack of efficient use of the high processing ability of such devices.

However, when the branch routes 24 are provided in a way separated from the main transport path 7 while installing therein those devices that are specially high in processing ability, it becomes possible to make use of such processing mechanisms at a plurality of steps.

For instance, in the case of the third embodiment, processing is done at the impurity diffusion processing mechanism 36 immediately after completion of the processing of the first process group 101'; if this is the case, this processing is performed within a shortened time period due to the fact that the impurity diffusion processing mechanism 36 is high in processing ability. Accordingly, such "idle" impurity diffusion processing mechanism 36 may be used for effectuation of the processing of another wafer substrate that has been subjected to the processing of the second process group 102'.

With such an arrangement, it is possible to utilize without any waste the processing mechanisms of high processing ability.

It must be noted that while in the third embodiment the impurity diffusion processing mechanism 36 having high processing ability is installed at the branch routes 24, such processing mechanism operatively associated with the branch routes 24 may be any type of processing mechanism, and should not exclusively be limited to the high-performance processing mechanism. The function of such processing mechanism is not questionable as far as efficient processing is achievable by separating a specific processing mechanism different in nature from the remaining processing mechanisms for installation to the branch routes.

It is also noted that although in the third embodiment the impurity diffusion processing mechanism 36 is singularly installed in the branch routes 24, a plurality of types of processing mechanisms may be installed in the branch routes 24 when necessary.

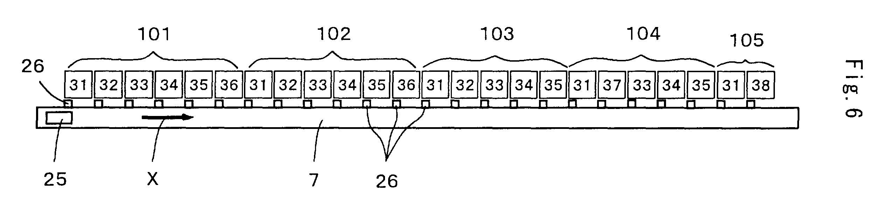

A fourth embodiment shown in Fig. 6 is an example which does not install a plurality of processing mechanisms constituting the unit process groups in the interior of the process boxes but install respective processing mechanisms directly along the transport path 7.

The processing mechanisms installed along the transport path 7 are the same in type as those used in the prescribed first to third embodiments. These processing mechanisms are laid out in the order of sequence of the semiconductor device manufacturing process steps.

A substrate carrier vehicle 25 is provided on the transport path 7, the vehicle 25 serving as a transport means for transferring a wafer substrate to each processing mechanism and being movable in the arrow X direction. This substrate carrier vehicle 25 constitutes the transport means of this invention along with the transport path 7, and is arranged so that it moves and stops in response to commands from a control CPU, not illustrated herein.

Each processing mechanism is assigned an address used for determination of the position thereof in a manner such that address IDs 26 are attached along the transport path 7. The address IDs 26 are like "beacon" indicators that indicate respective addresses concerned.

On the other hand, although not particularly depicted herein, the substrate carrier vehicle 25 comes with an ID sensor for reading the address IDs 26. The address IDs 26 are constituted from those capable of recognition by the substrate carrier vehicle 25 moving on the transport path 7, such as for example bar codes or the like. Then, the substrate carrier vehicle 25 mounting thereon a wafer substrate allows its ID sensor to read the address IDs 26 for detection of a present position of itself. The substrate carrier vehicle 25 moves on the transport path 7 while it transmits this detection signal to the control CPU.

In this way the control CPU can affirm the position of the substrate carrier vehicle 25 by use of the detection signal of the address ID as sent from the substrate carrier vehicle 25. In other words the fourth embodiment is such that the address IDs 26 and the ID sensor constitute the position detection means of this invention.

Also, the control CPU stores therein addresses of necessary processing mechanisms in accordance with the product type of a semiconductor device to be manufactured. When the substrate carrier vehicle 25 arrives at the address of a necessary processing mechanism, the CPU generates and issues a command or instruction for causing the vehicle to stop at the position.

A method for manufacturing the semiconductor device being the same as that of the first embodiment by using the manufacturing apparatus of the fourth embodiment will now be explained below.

The substrate carrier vehicle 25 moves from the left side in the arrow X direction on the transport path 7. It travels along the transport path 7 while it reads respective address IDs 26 as provided along the transport path 7; upon receipt of an instruction from the control CPU, the vehicle stops at a location in front of one necessary processing mechanism. Each processing mechanism is operable to take the wafer substrate from the substrate carrier vehicle 25 that presently stops, and applies required processing thereto, and then returns it to the substrate carrier vehicle 25. This will be repeated completing all the process steps so that it is possible to fabricate the intended semiconductor device.

In this way, it is possible to identify a present location of the substrate carrier vehicle 25 on an address-based management basis while enabling the control CPU to force the substrate carrier vehicle 25 to stop at a location in front of any necessary processing mechanism with increased reliability.

The capability of identifying a necessary processing mechanism required for effectuation of processing may in turn lead to an ability to identify unnecessary processing mechanisms in the adverse sense. In other words, even when unnecessary processing mechanisms are arrayed along the transport path 7, it becomes possible to transport the wafer substrate so that it passes them.

For example, processing mechanisms adapted for necessary process steps that are necessary to manufacture any available product types are disposed thus constituting the manufacturing apparatus. In the case one specific type of product is to be manufactured, the control CPU selects only those required for fabrication of such product type from among the processing mechanisms and then gives an appropriate instruction to the substrate carrier vehicle 25 whereby it becomes possible to allow the substrate carrier vehicle 25 to transfer the wafer substrate to those necessary processing mechanisms only.

With such an arrangement, one manufacturing apparatus can accommodate a variety of product types to thereby increase the useability and flexibility of the manufacturing apparatus.

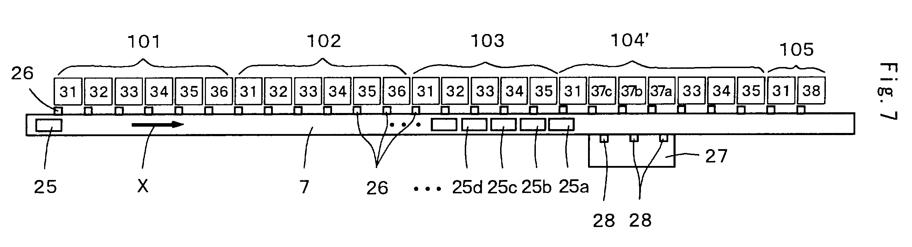

A fifth embodiment shown in Fig. 7 is the one which employs a serial continuous array of a plurality of processing mechanisms less in processing ability than the other processing mechanisms, which mechanisms are operable in a parallel fashion thereby increasing the processing ability thereof.

In the fifth embodiment shown, in cases where the sputter mechanism for formation of metal films at the electrode processing step is lower in processing ability than the other processing mechanisms, three sputter mechanisms 37a, 37b, 37c for formation of metal films are installed in parallel in one unit process group 104'. In addition, a refuge or "turnout" area 27 is provided at a location corresponding to these sputter mechanisms, the turnout 27 being provided with their address IDs 28. Further, the transport path 7 carries thereon a plurality of substrate carrier vehicles 25. The remaining configuration is the same as that in the third embodiment.

The three sputter mechanisms 37a, 37b, 37c constitute a processing mechanism group of this invention.

Under the control based on the control CPU addresses, the substrate carrier vehicles 25a, 25b, ... are operable to transport wafer substrates.

Firstly, when the "top" substrate carrier vehicle 25a mounts thereon a wafer substrate completed with the processing of the wash mechanism 31, it moves up to one of the three sputter mechanisms 37a, 37b, 37c--for example, the front end sputter mechanism 37a in the travel direction. At this sputter mechanism 37a, sputter processing is applied to the wafer substrate in the same way as in the other embodiments.

The next substrate carrier vehicle 25b mounts thereon a wafer substrate completed with the processing of the wash mechanism 31 and then transfers the wafer substrate to an idle sputter device in the processing mechanism group--for example, the second sputter mechanism 37b in the travel direction. Upon loading of the wafer substrate into the sputter mechanism 37b, the substrate carrier vehicle 25b goes into the turnout 27 and waits for completion of sputter processing.

If the sputter mechanisms 37a, 37b are busy with effectuation of processing, the third sputter mechanism 37c remains idle; accordingly, the third substrate carrier vehicle 25c behaves to transfer its wafer substrate to the sputter mechanism 37c and then enters the turnout 27 for waiting for completion of the processing.

By arranging the timing so that the processing at the initial sputter mechanism 37a is completed when the wafer substrate of the next substrate carrier vehicle 25b completes its intended processing of the wash mechanism 31, the substrate carrier vehicle 25d can transfer its wafer substrate toward the sputter mechanism 37a. At this time, the substrate carrier vehicles 25b and 25c are residing in the turnout 27. Thus, the substrate carrier vehicle 25d can pass the substrate carrier vehicles 25b and 25c stopping at the turnout 27 to transfer its wafer substrate toward the sputter mechanism 37a. This substrate carrier vehicle 25d also enters the turnout 27 to come to rest.

This is in order to enable a substrate carrier vehicle carrying its wafer substrate completed with the processing at the sputter mechanisms 37b, 37c to pass the substrate carrier vehicle 25d while the sputter processing is being carried out in the sputter mechanism 37a.

With such an arrangement, even where a plurality of substrate carrier vehicles 25 operate to successively transfer wafer substrates, it will no longer happen that one following substrate carrier vehicle 25 is required to wait until its aimed processing mechanism becomes idle at the location on this side of such processing mechanism which is less in processing ability than the remaining mechanisms. This can be said because any substrate carrier vehicle is permitted to carry and transfer its wafer substrate while selecting an idle processing mechanism from the processing mechanism group.

It is also possible to successively transfer the wafer substrates toward those processing mechanisms high in processing ability as disposed in the post stage of the low processing-ability mechanisms, which in turn makes it possible to continuously operate such processing mechanisms high in processing ability without any interruptions.

Accordingly, it is possible to increase the processing ability as a whole.

It is noted that the processing mechanism group should not be limited only to the sputter mechanisms, and may alternatively be configured from an array of a plurality of mechanisms low in processing ability than the others. This processing mechanism group should not be provided singularly and may be installed in the plural form. Even in such a case, any refuge or turnout areas corresponding to respective ones are identifiable based on addresses assigned thereto; therefore, it is possible for the control CPU to guide the substrate carrier vehicle 25 to rest in any appropriate one of such turnouts.

Additionally, the addresses and address IDs adhered to the unit process groups may be assigned per each processing mechanism, or alternatively, per process box. Still alternatively, these may be added to any other locations. To make a long story short, any configurations are employable as far as these insure reliable detectability of wafer substrate positions and enhanced identifiability of a certain location at which the transfer means should stop.

In addition, in the fourth and fifth embodiments, these are designed such that the substrate carrier vehicle 25 comprises its ID sensor which detects a present vehicle location to send forth a detection signal toward the control CPU, which then affirms a present location of the substrate carrier vehicle 25. However, the means for detecting a position of the carrier vehicle 25 should not exclusively be limited thereto. For instance, a present vehicle location may alternatively be determined by providing sensors on the transport path at predetermined intervals and detecting pass-through of the substrate carrier vehicle 25. Note here that it is preferable that such sensors be provided on the side of the transfer means rather than on the transport path because the latter may reduce the total number of necessary sensors thus saving production costs.

The above-mentioned first to fifth embodiments are designed so that a plurality of unit process groups are disposed to constitute a manufacturing apparatus being equipped with all the process steps required in the manufacture of a semiconductor device. However, the semiconductor device manufacturing apparatus of this invention also includes a manufacturing apparatus including selected unit process groups for use in forming only specific part of a semiconductor device.

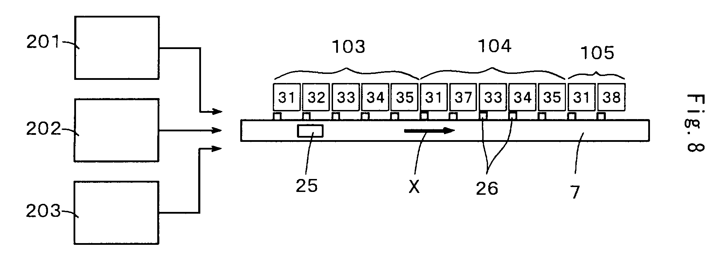

Fig. 8 shows one utilization form of such manufacturing apparatus for use in forming the entire structure of a semiconductor device, which apparatus is configured by combining the semiconductor device manufacturing apparatus of the sixth embodiment having only selected process steps with another process steps different from this apparatus.

The manufacturing apparatus of the sixth embodiment is equipped with only the process groups 103-105 corresponding to those steps that follow the electrode position determination step, which are selected from the semiconductor device fabrication flow shown in Fig. 2. These unit process groups 103-105 are such that respective unit process groups are serially disposed along the transport path 7 in the same manner as that of the third to fifth process groups of the fourth embodiment shown in Fig. 6, thereby constituting the manufacturing apparatus of this embodiment. Similarly, those processing mechanisms constituting respective unit process groups are arrayed in the processing order.

This embodiment is similar to the fourth embodiment in that the substrate carrier vehicle 25 travels on the transport path 7 while it reads respective address IDs 26 as provided to the transport path 7 and that necessary processes are successively applied to the wafer substrate.

Use of the manufacturing apparatus of the sixth embodiment makes it possible to fabricate lead-wire layers on the wafer substrate being transferred along the transport path 7.

It is possible, by serially disposing the processing mechanisms for use in processing the wafer substrate along the transport path 7, to enhance the semiconductor device production efficiency while simplifying the wafer substrate's travel route during the lead layer fabrication process.

In addition, as shown in Fig. 8, it becomes possible to comprise processing steps 210, 202, 203 separately from the prescribed manufacturing apparatus.

These processing steps 201-203 are the processes for forming P-type layers and N-type layers. More specifically, these are the steps of performing processing of certain parts corresponding to 101, 102 in the flow of Fig. 2. The configuration of these processing steps 201-203 may be of any ones. One example is that they are respective processing mechanisms as serially arrayed in the processing order as in the first and second process groups 101, 102 shown in Fig. 6. Another example is that they may be bay-system devices as in the prior art. A further example is that they are in combination of these arrangements.

In summary, any configurations are employable as far as the intended P-type layer and N-type layer can be fabricated on a wafer substrate by use of the processing steps 201, 202, 203.

These process steps 201, 202, 203 are the processes for formation of P-type layers and N-type layers which accommodate different product types, respectively.

An explanation will now be given of a method of forming the transistor shown in Fig. 12 by disposing in parallel such processing steps 201-203 which can accommodate different product types along the transport path 7.

After formation of the intended layers including the P-type layer and N-type layer on a wafer substrate at the process steps 201, 202, 203, this substrate is mounted on the substrate carrier vehicle 25 on the transport path 7. The wafer substrate mounted on the substrate carrier vehicle 25 is then subject to fabrication of lead-wire layers and inspection in the unit process groups 103-105.

In this way, even where several layers accommodating a variety of product types are formed by use of such different process steps 201-203, it is possible to form the intended lead layers using a single manufacturing apparatus of the sixth embodiment.

Note that it is also possible to effectuate processing in a separate cleanroom in which the processing steps 201-203 are provided. It is further possible that a wafer substrate completed with the intended processing is once stored in a wafer stocker, not shown, and then taken out of it, and thereafter mounted on the substrate carrier vehicle 25 on the transport path 7.

Although in the sixth embodiment the manufacturing apparatus is designed so that the processing mechanisms or unit process groups are disposed along the transport path 7 at a certain process part capable of common utilization to respective product types, such as for example lead layer formation, to thereby constitute the manufacturing apparatus, the layout of processing mechanisms may be implemented in any available configurations at the remaining process steps to be combined with this manufacturing apparatus. It is possible to efficiently manufacture a plurality of types of products by using those process steps which are configured in a suitable form that is convenient to accommodate respective product types.

Optionally, the manufacturing apparatus comprised of the unit process groups of this invention may also be ones that accommodate any process part in the manufacture of a semiconductor device.

While the manufacturing apparatus of the sixth embodiment is the apparatus for use in forming lead layers of a semiconductor device, this may be modified in a way such that the process steps 201-203 are connected to the transport path 7 providing a single manufacturing apparatus. In this case it is also possible to automatically mount for transportation a processing-completed wafer substrate on the substrate carrier vehicle 25.

Since the semiconductor device manufacturing apparatus of the first invention is arranged to include a serial array of unit process groups causing the transfer direction of a wafer substrate to be extend in a single direction, it becomes possible to simplify the wafer substrate transport route configuration. Thus, the resulting transport route is minimized.

In addition, since the transport routes of a plurality of wafer substrates will no longer intersect each other, any wait time does not take place.

Accordingly, as compared to the prior art apparatus, any duplicate or "dead" route segments and wait time are eliminated improving the production efficiency.

In the second invention, since it comprises a group constituted by processing functions as serially disposed in the order of wafer substrate processing, any dead route segments and wait time are avoided at such part thereby increasing the productivity.

According to the third and fourth inventions, the wafer substrate transport paths within the unit process group may be simplified along with the wafer substrate transport path among the unit process groups, thereby enabling achievement of manufacture with more increased efficiency.

According to the fifth invention, it is possible to separate one or more specific processing functions from the remaining processing functions within the unit process groups for installation in the branch routes, which in turn makes it possible to efficiently use them without having to let high-performance devices be in the idle state. Further, if a large-scale mechanism is installed in the branch routes, then it is no longer required that such large-size equipment be provided per unit processing process group. Consequently, the apparatus may be downsized as a whole.

According to the sixth to ninth inventions, since the clean benches are provided along the transport route of a wafer substrate thereby forming the clean space, any cleanroom for installation of the transport route is no longer required. This makes it possible to likewise reduce facility costs.

Especially, in the seventh to ninth inventions, since it is possible to uniformly adjust the flow direction of clean air so that it is toward the transport route, thereby enabling clean air injected from the clean benches to decrease in flow amount while downsizing the clean benches.

According to the tenth to thirteenth inventions, it is possible by using the position detection mechanism to affirm the position of a wafer substrate under delivery while enabling the control CPU to halt the wafer substrate transfer means at any location required. This makes it possible to select an appropriate one from among the processing mechanisms as disposed along the transport path for effectuation of the intended processing.

In particular, with the eleventh invention, since the address detecting sensor is provided in the transfer means per se, the number of sensors may be reduced as compared to the case where these are provided on the side of the transport path, which results in a decrease in cost.

Further, according to the twelfth invention, it is possible to increase the useability and flexibility of the manufacturing apparatus.

Furthermore, according to the thirteenth invention, the total processing ability may be increased.

According to the fourteenth invention, a unit process group having those processing mechanisms that are difficult in achieving the intended serial layout in the processing order is also incorporated in the manufacturing apparatus to thereby enable the production efficiency to increase.

### Explanation of Reference Numerals

- 6: clean bench
- 6a: air guide
- 7: transport path
- 24: branch route
- P(1)-P(5): process box
- 25: substrate carrier vehicle
- 26, 28: address ID
- 27: refuge area
- 31: wash mechanism
- 32: oxide film fabrication mechanism
- 33: photosensitive material coat mechanism
- 34: development mechanism
- 35: chemical treatment mechanism
- 36: impurity diffusion processing mechanism
- 37: sputter mechanism
- 37a, 37b, 37c: sputter mechanism
- 38: inspection mechanism
- 39: clean space
- 101-105: unit process group
- 101', 102': unit process group
- 104': unit process group

## Claims

1. An apparatus for manufacturing a semiconductor device, characterized in that unit process groups 101-105, 101', 102', 104' are each constituted from a plurality of processing mechanisms 31-38 including washing and film formation at steps of forming individual layers of a wafer substrate, and by comprising unit process groups wherein these plurality of unit process groups are serially disposed along a main route 7 for transportation of the wafer substrate.

2. An apparatus for manufacturing a semiconductor device, characterized by comprising unit process groups connected to a main route 7 for transportation of a wafer substrate, and in that these unit process groups 101-105, 101', 102', 104' include a plurality of processing mechanisms 31-38 such as washing and film formation and others at those steps of forming individual layers of the wafer substrate, the mechanisms being serially disposed in an order of processing of the wafer substrate.

3. The apparatus for manufacturing a semiconductor device according to claim 1, characterized in that the unit process groups include a unit process group 101-105, 101', 102', 104' having a plurality of processing mechanisms 31-38 being serially disposed in an order of processing of the wafer substrate.

4. The apparatus for manufacturing a semiconductor device according to claim 2, characterized in that a plurality of unit process groups 101-105, 101', 102', 104' are serially disposed along the main route 7 for transportation of the wafer substrate.

5. The apparatus for manufacturing a semiconductor device according to any one of the preceding claims 1 to 4, characterized in that a branch route 24 diverted from the main route 7 is provided, and that a specific processing mechanism selected from all the processing mechanisms is installed on the branch route.

6. The apparatus for manufacturing a semiconductor device according to any one of claims 1 to 5, characterized in that a clean bench is provided with predetermined intervals along the transport route 7 for transportation of the wafer substrate, and that this clean bench 6 injects clean air toward the transport route thereby forming a clean space 39 between the route 7 and the clean bench.

7. The apparatus for manufacturing a semiconductor device according to claim 6, characterized in that an air guide 6a extending downward is provided at an edge of the clean bench 6 along the direction of the wafer substrate transport route 7.

8. The apparatus for manufacturing a semiconductor device according to claim 6 or 7, characterized in that a fence member surrounding the clean space 39 is provided between the clean bench 7 and the transport route 7.

9. The apparatus for manufacturing a semiconductor device according to claims 6 to 8, characterized in that an air exhaust port is provided beneath the clean space 39.

10. The apparatus for manufacturing a semiconductor device according to any one of the preceding claims 1 to 9, characterized by comprising a transport mechanism including a transport route consisting essentially of one or both of a main route 7 and a branch route 24 along with a carrier body 25 movable on the transport route with a wafer substrate mounted thereon, a position detection mechanism for detecting a position of the carrier body that this transport mechanism has, and a control CPU for letting the carrier body move or step in accordance with a detection signal from the position detection mechanism.

11. The apparatus for manufacturing a semiconductor device according to claim 10, characterized in that the position detection mechanism comprises an address ID representative of a position provided along the transport routes 7, 24 and an ID sensor for reading the address ID 26 provided to the carrier body, and that the ID sensor transmits to the control CPU the address ID as read during traveling whereas the control CPU controls motion of the carrier body 25 on the basis of the address ID 26 sent thereto.

12. The apparatus for manufacturing a semiconductor device according to claim 10 to 11, characterized in that unit process groups accommodating any available product types are provided along the transport route of the wafer substrate, and that the control CPU selects only a unit process group or groups required during traveling of the carrier body 25.

13. The apparatus for manufacturing a semiconductor device according to any one of the preceding claims 10 to 12, characterized by comprising a processing mechanism group including a plurality of successive processing mechanisms of the same type which are less in processing ability than the other processing mechanisms as provided along the transport route 7, and a refuge area 27 provided at part corresponding to the processing mechanism group along the transport route, and in that the control CPU controls a plurality of carrier bodies 25 moving on the transport route 7 and also forces a carrier body 25 transferring a wafer substrate to said processing mechanism group to stop at the refuge area 27 thereby enabling its following carrier body 25 to pass the stopping carrier body 25.

14. The apparatus for manufacturing a semiconductor device according to any one of the preceding claims 1 to 13, characterized by comprising a random unit process group wherein processing mechanisms are disposed at random as in the bay scheme.
